# EUROPEAN PATENT SPECIFICATION

(11) **EP 0 247 893 B1**
(45) Date of publication and mention of the grant of the patent: **24.02.1993**
(21) Application number: 87304781.5
(22) Date of filing: 29.05.1987
(51) Int. Cl.: G02F 1/13, H05K 3/36, H05K 3/40, H01R 35/02

(54) **Flat display panel**
Flache Display-Anzeigetafel
Panneau d'affichage plat

(30) Priority: 30.05.1986 JP 126579/86
(43) Date of publication of application: 02.12.1987
(73) Proprietor: SHARP KABUSHIKI KAISHA, Osaka 545 (JP)
(72) Inventor: Nakatani, Hiroshi, Tenri-shi Nara-ken (JP); Kawaguchi, Hisao, Nara-shi Nara-ken (JP); Nakabu, Shigeo, Nara-shi Nara-ken (JP)
(74) Representative: Brown, Kenneth Richard

(56) References cited:
- EP-A- 0 030 167
- GB-A- 2 041 614
- PROCEEDINGS OF THE SID, vol. 23, no. 1, 1982, pp 3-8, Los Angeles, CA, US, E. KANEKO et al.: "A posket-size liquid-crystal TV display".

## Description

The present invention relates to a flat display panel for application to a thin display device such as a liquid crystal color TV.

Our present Information Age demands quick and accurate access to various information. A personal information display device has drawn attention as promising means for this purpose. For personal use, low voltage, power-saving, thin and small information display devices are demanded. A liquid crystal matrix display panel meets these requirements to some extent. Research and development of the liquid crystal matrix display panel is now under way in various industrial fields, particularly focusing on a liquid crystal color TV.

The matrix display panel for a liquid crystal color TV has two types: active matrix type and simple matrix type. The active matrix display panel comprises a plurality of signal electrodes and a plurality of scanning electrodes arranged in a matrix, and a switching transistor and a liquid crystal driving electrode being formed in each intersection of the electrodes to constitute a picture element. The switching transistors, driven by external signals, select necessary picture elements, thereby displaying a picture. Voltage on each liquid crystal-driving electrode is applied to the liquid crystal statistically. In contrast, the simple matrix display panel comprises two glass substrates one including a plurality of signal electrodes and the other including a plurality of scanning electrodes, the two substrates being superimposed on each other so that the signal electrodes and the scanning electrodes are arranged in a matrix. The picture element in each intersection of the electrodes is driven dynamically. In either matrix panel type, the signal electrodes and scanning electrodes are extended outside the picture element region and connected to the output terminals of LSI's, respectively. A color filter is indispensable in the panel. Moreover, the panel is required to transmit light and involves a light source such as a fluorescent lamp.

As a typical liquid crystal active matrix color display panel, the conventional liquid crystal display module including a substrate on which LSI's for driving the matrix are mounted is described in the following.

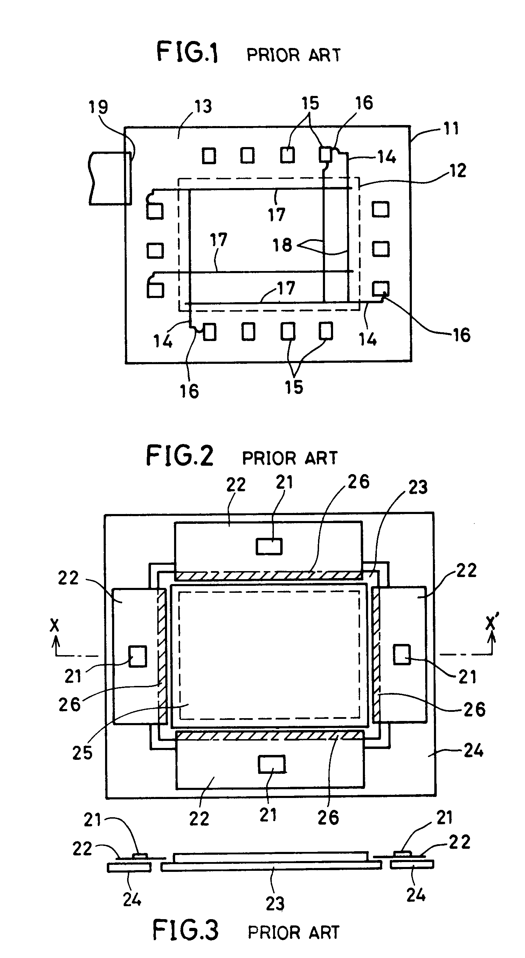

Fig. 1 shows an example of the conventional liquid crystal display module. A wiring region with distributing electrodes 14 formed thereon is provided in the peripheral region 13 of the picture element region 12 of a liquid crystal display panel 11, so that liquid crystal driving LSI's 15 can be mounted directly on the display panel 11. Input and output leads are connected to the pads 16 of the LSI's 15 either in wire bonding, TAB or flip chip bonding method.

In the liquid crystal display module of the above construction, the wiring region and the LSI's-mounting region are located in the peripheral region 13 of the picture element region of the liquid crystal display panel 11. In addition, the panel 11 must include another region 19 for connection with an external circuit which supplies signals to the LSI's 15. Consequently, the area of the display panel 11 becomes rather large compared with that of the picture element region 12. Particularly when the display panel of this type is used in a portable display device with two to three inch screen, the area occupied by the wiring region, LSI-mounting region and external circuit-connecting region is obviously large for the screen size. As the display panel is larger, the number of display panels to be obtained from a glass substrate sheet of a given size decreases, resulting in cost increase. Besides, in case numerous LSI's are loaded, the input signal lines must have multilayer interconnection, to effect simpler structure and smaller area of the region for connecting the input signal lines of the LSI's to the external circuit. This measure would, however, sacrifice the yield as a liquid crystal display module.

A proposed construction to remove the above disadvantages is such that a flexible substrate on which liquid crystal driving LSI's are mounted is connected to a liquid crystal display panel by soldering or with thermoplastic anisotropic conductive sheets or anisotropic conductive rubber connectors. The proposed construction is described in detail below.

Fig. 2 is a plan view of a second example of the conventional liquid crystal matrix display panel, and Fig. 3 is a sectional view taken along the line X-X' of Fig. 2. A flexible substrate 22 with liquid crystal driving LSI's 21 loaded thereon is positioned properly with respect to the electrodes on a liquid crystal display panel 23 and connected to the panel 23 by soldering. The other end of the flexible substrate 22 is connected by soldering with a 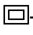 -shaped double side PC board 24 on which input signal lines (common wiring) are printed.

Since the LSI's 21 are mounted on the flexible substrate 22, the liquid crystal display panel 23 may be of the size large enough to accomodate a picture element region 25 and a joint margin 26 for connection with the flexible substrate 22. Accordingly, the liquid crystal display panel 23 can be made small, resulting in cost reduction. However, the PC board 24 is placed on the same plane as the liquid crystal display panel 23 as shown in Fig. 3, the entire set size increases with the screen size, providing a fatal barrier to a portable display device. In addition, when chip components and controllers requiring shields as the LSI's do are to be mounted on the PC board 24, the PC board 24 must be made larger. Besides, there is a height restriction for the components to be mounted.

A display panel, in which the vertical and horizontal electrodes of the LCD panel are connected to the driver boards etc. via a flexible printed circuit connector is described in '2320 proceedings of the SID' 23 (1982) No. 1 p3-8.

Accordingly, an object of the present invention is to alleviate at least some of the aforementioned problems.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the scope of the invention will become apparent to those skilled in the art from this detailed description.

In accordance with the present invention there is provided a display device comprising:
a display panel having a display area and a connection area between an edge of said display area and an edge of said display panel; and
a flexible substrate which supports display drive circuitry and which is connected to said display panel at said connection area, and projects outwardly from said edge of said display panel,
characterised in that said display device further comprises a first frame disposed outwardly of said edge of said display panel, and a second frame disposed beneath said first frame, said flexible substrate being folded double along an outer fold formed outwardly of said edge of said display panel so that a part of said flexible substrate extends inwardly from said outer fold toward said display area, said outer fold being formed round an outer edge of said first frame, said part being disposed between a lower face of said first frame and an upper face of said second frame, said flexible substrate being further folded double along an inner fold formed inwardly of said outer fold so that another part of said flexible substrate extends outwardly from said inner fold, said flexible substrate forming a substantially S-shaped sectional profile.

Since the flexible substrate is folded into an S shape in section along the upper and lower frames and mounted adjacent to the picture element region, a wiring region, an LSI-mounting region and an external circuit-connecting region on the outside of the picture element region are allowed to provide a multilayer construction. Therefore, increase in the screen size results in increase in the entire set size but with a smaller increase ratio than in the conventional display panels. Besides, the height restriction is relieved for components to be mounted on the PC board. As a result, the flat display panel can be made smaller and produced at a lower cost. Furthermore, owing to the fact that the chip components can be mounted on the PC board at any desired position in the longitudinal or lateral direction from the picture element region, the present invention can be easily applied to both vertical and lateral display devices.

The present invention will be better understood from the detailed description given hereinbelow and the accompanying drawings which are given by way of illustration only, and thus are not limitative of the present invention and wherein:
Fig. 1 is a plan view of an example of the conventional flat display panel;
Fig. 2 is a plan view of another example of the conventional flat display panel;
Fig. 3 is a sectional view taken along the line X-X' of Fig. 2;
Fig. 4 is a plan view of an embodiment of a flat display panel of the present invention; and
Fig. 5 is a sectional view taken along the line II-II' of Fig. 4.

According to an embodiment of the present invention, a flexible substrate 2 with a liquid crystal-driving LSI 1 mounted thereon is provided adjacent to a picture element region 5, and the flexible substrate 2 is folded along two upper and lower frames 3 and 4 so that a part 2a of the flexible substrate 2 is placed between the upper and lower frames 3 and 4. In other words, the flexible substrate 2 is formed into an S shape in section as shown in Fig. 5. The structure thus composed of the flexible substrate 2 and the frames 3 and 4 is provided adjacent to all the four sides of the picture element region 5 of a liquid crystal display panel 6. A gap "d" is provided between the frame 3 and the display panel 6.

The flat display panel of the present invention is manufactured in the following process. An end portion 2b of the flexible substrate 2 is connected to the liquid crystal display panel 6 by soldering or with a thermoplastic anisotropic conductive sheet or an anisotropic conductive rubber connector. With the resulting display module (comprising the display panel 2 connected to the flexible substrate 2) being fit on the upper frame 3, the flexible substrate 2 is folded along the right side and bottom surfaces of the upper frame 3 as shown in Fig. 5. The lower frame 4 formed integrally with a PC board 7 is fixed to the upper frame 3 by screws through the portion 2a of the flexible substrate 2. The flexible substrate 2 is then folded along the left side and bottom surfaces of the lower frame 4 as shown in Fig. 5. The other end portion 2c of the flexible substrate 2 is connected to the PC board 7 by soldering or with a thermoplastic anisotropic conductive sheet or an anisotropic conductive rubber connector. Input signal lines (not shown) and a controller component 8 is mounted on the PC board 7 in advance.

The PC board 7 connected to the folded flexible substrate 2 projects rightward (of Fig. 5) from the flexible substrate 2. The controller component 8 is mounted at the projected portion 7a of the PC board 7.

According to the present embodiment, the distance "P" between the top surface of the PC board 7 and the top surface of the liquid crystal display panel 6 is about 3mm--sufficiently large to accommodate the height of chip components to be mounted on the PC board 7, so there is virtually no height restriction for the chip components. If a wide tape carrier with an LSI 1 mounted thereon by inner lead bonding is used as the flexible substrate 2, the device mounting process can be omitted and no additional wiring substrate is necessary, which results in cost reduction.

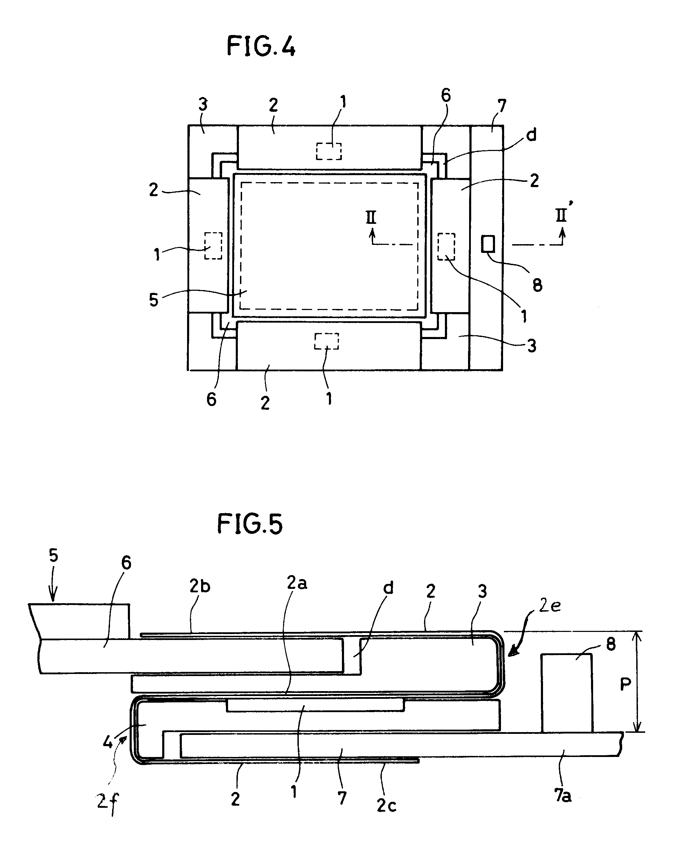

As mentioned earlier, the flexible substrate 2 folded into an S shape along the frames 3 and 4 is mounted adjacent to all the four sides of the picture element region 5 of the liquid crystal display panel 6, and the PC board 7 may be projected from the flexible substrate 2 in any desired direction: rightward as shown in Fig. 4, leftward, upward or downward depending upon the shape of a display device to which the present invention is applied. Specifically, for a vertical pocketable display device, for instance, the PC board 7 is projected upward, downward or in both directions so that the controller component 8 can be mounted on the vertically projected portion for reduction in the lateral dimension. For a lateral type, on the other hand, the PC board 7 is projected rightward, leftward or in both directions so that the controller component 8 can be mounted on the laterally projected portion for reduction in the vertical dimension.

In the present embodiment of the invention, the driving LSI 1 is disposed under the liquid crystal display panel 6 to make the display device smaller.

In the above embodiment, the invention is applied to an active liquid crystal matrix display panel. It is not to mention that the invention is applicable to a general flat display panel including an EL.

The invention being thus described, it will be obvious that the same may be varied in many ways. Such variations are not to be regarded as a departure from the scope of the invention, and all such modifications are intended to be included within the scope of the following claims.

## Claims

1. A display device comprising:
a display panel (6) having a display area (5) and a connection area between an edge of said display area and an edge of said display panel; and
a flexible substrate (2) which supports display drive circuit (1) and which is connected to said display panel at said connection area, and projects outwardly from said edge of said display panel,
characterised in that said display device further comprises a first frame (3) disposed outwardly of said edge of said display panel, and a second frame (4) disposed beneath said first frame, said flexible substrate being folded double along an outer fold(2e) formed outwardly of said edge of said display panel so that a part (2a) of said flexible substrate extends inwardly from said outer fold (2e) toward said display area, said outer fold being formed round an outer edge of said first frame, said part (2a) being disposed between a lower face of said first frame and an upper face of said second frame, said flexible substrate being further folded double along an inner fold (2f) formed inwardly of said outer fold so that another part (2c) of said flexible substrate extends outwardly from said inner fold (2f), said flexible substrate forming a substantially S-shaped sectional profile.

2. A display device according to claim 1 characterised in that said another part (2c) is connected to a PC board of which a part (7a) which lies outwardly of said outer fold carries further circuit (8).

3. A display device according to claim 1 or claim 2 characterised in that said flexible substrate (2) comprises a wide tape carrier.

4. A display device according to any of claims 1 to 3 characterised in that said display drive circuit (1) is mounted on said flexible substrate (2) at a portion between said first and second frames.

5. A display device according to claim 4 characterised in that said second frame (4) is provided with a recess for positioning said display drive circuit (1).

6. A display device according to any one of claims 1 to 5 characterised in that said display drive circuit (1) comprises an LSI.

7. A display device according to any one of claims 1 to 5 characterised in that said display panel (6) comprises a liquid crystal display device.

8. A display device according to any one of claims 1 to 5 characterised in that said display panel (6) comprises an electroluminescent display device.

## Patentansprüche

1. Anzeigevorrichtung mit
einer Anzeigetafel (6) mit einem Anzeigebereich (5) und einem zwischen einer Kante des Anzeigebereichs und einer Kante der Anzeigetafel liegenden Verbindungsbereich und
einem flexiblen Substrat (2), das eine Anzeigetreiberschaltung (1) trägt und in dem Verbindungsbereich mit der Anzeigetafel verbunden ist und von der genannten Kante der Anzeigetafel nach außen ragt,
**dadurch gekennzeichnet,**
daß die Anzeigevorrichtung ferner aufweist:
einen ersten Rahmen (3), der außerhalb der Kante der Anzeigetafel angeordnet ist sowie einen zweiten Rahmen (4), der unterhalb des ersten Rahmens angeordnet ist,
daß das flexible Substrat längs eines außerhalb der genannten Kante der Anzeigetafel gebildeten äußeren Falzes (2e) doppelt gefaltet ist, so daß ein Teil (2a) des flexiblen Substrats sich von diesem äußeren Falz (2e) in Richtung auf den Anzeigebereich nach innen erstreckt,
daß der äußere Falz um eine Außenkante des ersten Rahmens gebildet ist,
daß der genannte Teil (2a) des flexiblen Substrats zwischen der Unterseite des ersten Rahmens und der Oberseite des zweiten Rahmens angeordnet ist,
daß das flexible Substrat außerdem längs eines innerhalb des äußeren Falzes gebildeten inneren Falzes (2f) doppelt gefaltet ist, so daß weiterer ein Teil (2c) des flexiblen Substrats sich von dem inneren Falz (2f) nach außen erstreckt, so daß das flexible Substrat ein im wesentlichen S-förmiges Querschnittsprofil besitzt.

2. Anzeigevorrichtung nach Anspruch 1, dadurch gekennzeichnet, daß der weitere Teil (2c) des flexiblen Substrats mit einer PC-Schaltungsplatte verbunden ist, von der ein Teil (7a), der außerhalb des äußeren Falzes liegt, weitere Schaltungsteile (8) trägt.

3. Anzeigevorrichtung nach Anspruch 1 oder 2, dadurch gekennzeichnet, daß das flexible Substrat (2) einen breiten Bandträger umfaßt.

4. Anzeigevorrichtung nach einem der Ansprüche 1 bis 3,dadurch gekennzeichnet, daß die Anzeigetreiberschaltung (1) auf dem flexiblen Substrat (2) in einem Bereich zwischen dem ersten und dem zweiten Rahmen angeordnet ist.

5. Anzeigevorrichtung nach Anspruch 4, dadurch gekennzeichnet, daß der zweite Rahmen (4) eine Ausnehmung zur Unterbringung der Anzeigetreiberschaltung (1) aufweist.

6. Anzeigevorrichtung nach einem der Ansprüche 1 bis 5, dadurch gekennzeichnet, daß die Anzeigetreiberschaltung (1) eine LSI-Schaltung enthält.

7. Anzeigevorrichtung nach einem der Ansprüche 1 bis 5, dadurch gekennzeichnet, daß die Anzeigetafel (6) eine Flüssigkristall-Anzeigevorrichtung enthält.

8. Anzeigevorrichtung nach einem der Ansprüche 1 bis 5, dadurch gekennzeichnet, daß die Anzeigetafel (6) eine Elektroluminiszenz-Anzeigevorrichtung enthält.

## Revendications

1. Dispositif d'affichage, comprenant :
un panneau d'affichage (6) ayant une zone d'affichage (5) et une zone de connexion entre un bord de la zone d'affichage et un bord du panneau d'affichage, et
un substrat souple (2) qui supporte un circuit (1) de pilotage d'affichage et qui est connecté au panneau d'affichage dans la zone de connexion et qui dépasse à l'extérieur du bord du panneau d'affichage,
caractérisé en ce que le dispositif d'affichage comporte en outre un premier cadre (3) disposé à l'extérieur du bord du panneau d'affichage, et un second cadre (4) disposé sous le premier cadre, le substrat souple étant replié en double le long d'un pli externe (2e) formé vers l'extérieur du bord du panneau d'affichage afin qu'une partie (2a) du substrat souple soit dirigée vers l'intérieur depuis le pli externe (2e) vers la zone d'affichage, le pli externe étant arrondi autour d'un bord externe du premier cadre, ladite partie (2a) étant placée entre la face inférieure du premier cadre et une face supérieure du second cadre, le substrat souple étant en outre replié en double le long d'un pli interne (2f) formé vers l'intérieur du pli externe afin qu'une autre partie (2c) du substrat souple dépasse vers l'extérieur du pli interne (2f), le substrat souple donnant un profil en coupe pratiquement en S.

2. Dispositif d'affichage selon la revendication 1, caractérisé en ce que l'autre partie (2c) est connectée à une carte de circuit imprimé dont une partie (7a) qui se trouve à l'extérieur du pli externe porte des circuits supplémentaires (8).

3. Dispositif d'affichage selon la revendication 1 ou 2, caractérisé en ce que le substrat souple (2) est un support de ruban de grande largeur.

4. Dispositif d'affichage selon l'une quelconque des revendications 1 à 3, caractérisé en ce que le circuit de pilotage (1) de l'affichage est monté sur le substrat souple (2) dans une partie comprise entre le premier et le second cadre.

5. Dispositif d'affichage selon la revendication 4, caractérisé en ce que le second cadre (4) a une cavité de positionnement du circuit (1) de pilotage de l'affichage.

6. Dispositif d'affichage selon l'une quelconque des revendications 1 à 5, caractérisé en ce que le circuit (1) de pilotage d'affichage est un circuit LSI.

7. Dispositif d'affichage selon l'une quelconque des revendications 1 à 5, caractérisé en ce que le panneau d'affichage (6) est un dispositif d'affichage à cristaux liquides.

8. Dispositif d'affichage selon l'une quelconque des revendications 1 à 5, caractérisé en ce que le panneau d'affichage (6) est un dispositif d'affichage électroluminescent.
